# EUROPEAN PATENT APPLICATION

(11) **EP 4 528 829 A1**
(43) Date of publication of application: **26.03.2025**
(21) Application number: 23199516.8
(22) Date of filing: 25.09.2023
(51) Int. Cl.: H01L 31/05

(54) **ASSEMBLY FOR ELECTRICALLY CONTACTING AND ELECTRICALLY CONNECTING PHOTOVOLTAIC CELLS AND METHOD FOR FABRICATING SUCH ASSEMBLY**

(71) Applicant: Imec VZW, 3001 Leuven (BE); Universiteit Hasselt, 3500 Hasselt (BE)
(72) Inventor: Borgers, Mr. Tom, 3001 Leuven (BE); Govaerts, Mr. Jonathan, 3001 Leuven (BE)
(74) Representative: Patent Department IMEC

(57) **Abstract**

An assembly (1, 2) for electrically contacting and connecting photovoltaic cells (21, 22, 23), is provided, comprising first and second electrically insulating foils (31, 32) laterally shifted in a first direction. The assembly comprises a plurality of electrically conductive wires (40) arranged substantially parallel to each other and substantially extending over both electrically insulating foils (31, 32) in the first direction, wherein the plurality of electrically conductive wires (40) is arranged on a first foil surface (311) of the first electrically insulating foil (31) and further on a second foil surface (322) of the second electrically insulating foil (32), being located at opposite sides of the assembly (1, 2). The plurality of electrically conductive wires (40) is locally attached to both electrically insulating foils (31, 32) without penetrating therethrough. A method (100) for fabricating the assembly is provided.

## Description

### Technical field

The present disclosure relates to assemblies for electrically contacting and electrically connecting photovoltaic cells and to photovoltaic devices comprising such assembly. The present disclosure further relates to methods for fabricating such assemblies, to methods for electrically interconnecting photovoltaic cells by means of these assemblies and to methods for fabricating photovoltaic devices.

### Background

Methods are known for electrically contacting and electrically connecting, electrically interconnecting, busbar-free photovoltaic cells. In such methods metal contacts, for example finger-shaped metal contacts, of the photovoltaic cells are typically contacted and connected by means of multiple electrically conductive wires. These electrically conductive wires may replace the traditional busbars and interconnectors. It is an advantage of such methods that a lower cost of photovoltaic modules can be achieved, e.g. due to a reduced metal consumption for the metallization and/or due to an increased module efficiency resulting from a lower series resistance and improved light harvesting.

EP1547158 describes an electrode for electrically contacting and electrically connecting busbar-free photovoltaic elements. The electrode comprises an electrically insulating optically transparent film, an adhesive layer on a planar surface of the film and a plurality of substantially parallel, electrically conductive wires embedded into the adhesive layer. The plurality of wires lies over the planar surface of the electrically insulating optically transparent film. The adhesive layer has a thickness less than the wires embedded therein, such that a part of the surfaces of the wires protrudes from the adhesive layer. The surfaces of the wires protruding from the adhesive layer are covered by a coating consisting of an alloy having a low melting point to facilitate soldering of the wires to the conductive surfaces of the photovoltaic elements. The electrode is only contactable at one side. To enable collecting current from the electrodes and transmitting it further, terminal bars are provided at the end of the wires. These terminal bars are provided on the adhesive, at locations outside the contour of the photovoltaic elements. The need for providing busbars disadvantageously leads to a reduction of the effective cell and module active area.

Electrically contacting a photovoltaic element with an electrode as disclosed in EP 1547158 is based on applying the electrode, including terminal bars, directly onto a metallized cell and performing a pressing and heating process, thereby bonding the wires to the metal fingers of the photovoltaic cell and to the terminal bars. Because of differences in thermal expansion coefficient between the cells and the wires, such heating process induces mechanical stress in the assembly, which may result in a reduced reliability of the electrical contacts. Electrically connecting photovoltaic elements is based on a similar pressing and heating process, wherein the electrodes are formed as a continuous strip, cut to a length corresponding to the length of an array of adjacent photovoltaic elements to be connected. This approach requires proper alignment of the cells to the electrodes, in particular to the terminal bars.

There is a need for electrodes that enable electrically contacting and electrically connecting busbar-free photovoltaic cells by means of a plurality of electrically conductive wires in an easy and reliable way, without the need for providing busbars and/or terminal bars, and that can be fabricated in an industrial environment and with high throughput.

### Summary

An objective of the present disclosure is to at least partly mitigate, alleviate or eliminate one or more of the above-identified limitations and disadvantages of the prior art, singly or in any combination. These and other objectives are at least partly met by the invention as defined in the independent claims. Preferred embodiments are set out in the dependent claims.

According to a first aspect the disclosure is related to an assembly for electrically contacting and electrically connecting, electrically interconnecting, photovoltaic cells, the assembly comprising a first part comprising a first electrically insulating foil, a second part comprising a second electrically insulating foil, wherein the first electrically insulating foil and the second electrically insulating foil are arranged relative to each other in respective positions that are laterally shifted in a first direction; and a plurality of electrically conductive wires arranged substantially parallel to each other in a wire direction and substantially extending over the first electrically insulating foil and over the second electrically insulating foil in the first direction, wherein the plurality of electrically conductive wires is arranged on a first surface, first foil surface, of the first electrically insulating foil and further on a second surface, second foil surface, of the second electrically insulating foil, the first foil surface and the second foil surface being located at opposite sides of the assembly, and wherein the plurality of electrically conductive wires is locally attached to the first electrically insulating foil and to the second electrically insulating foil at predetermined locations, predetermined attachment locations, without penetrating therethrough.

The assembly is particularly suitable for wire-based electrical contacting and wire-based electrical interconnection of busbar-free, bifacially contactable photovoltaic cells, meaning photovoltaic cells contactable at both sides. It may be used for electrical contacting and/or electrical interconnection of a broad range of photovoltaic cells, for example chalcogenide photovoltaic cells, such as CIGS, Copper Indium Gallium (di)Selenide) cells or Cadmium Telluride cells, perovskite photovoltaic cells, organic photovoltaic cells or silicon photovoltaic cells.

The assembly is flexible. This is advantageous in that it enables the fabrication of photovoltaic devices and photovoltaic modules suitable for integration on non-flat surfaces such as curved surfaces.

The first electrically insulating foil and the second electrically insulating foil may be made of the same material or of a different material. The first electrically insulating foil and/or the second electrically insulating foil may comprise a polymer foil, such as a polyolefin polymer foil or a thermoplastic foil. The first electrically insulating foil and/or the second electrically insulating foil may be a single-layer foil, or it may comprise a stack of multiple layers. In advantageous embodiments a multiple-layer foil comprising at least 3 layers may be used, wherein the outer layers have a melting temperature that is lower than the melting temperature of the layers sandwiched therein between.

A fiber material such as a glass fiber material, a basalt fiber material or a natural fiber material such as flax fiber or hemp fiber, may be embedded in the foils, for example in the form of a plurality of chopped fibers. This advantageously improves the mechanical strength of the assembly and its resistance against mechanical damage. The first and second electrically insulating foils may have a rectangular shape. The width and the length of each of the electrically insulating foils typically depend on the size of the photovoltaic cells to be electrically interconnected therewith. The width and the length of each of the electrically insulating foils may further be selected based on other considerations, such as the amount of lateral shift between the first electrically insulating foil and the second electrically insulating foil in the first direction. Typical dimensions of the electrically insulating foils are a width, a size in the first direction, in the range between 100 and 200 mm and a length, a size in a second direction substantially orthogonal to the first direction, in the range between 300 and 500 mm, but other dimensions are possible. The foils may have a thickness in the range between 50 micrometers and 1 mm, for example in the range between 50 micrometers and 0.5 mm, such as between 50 micrometers and 150 micrometers. For example, for an insulating foil in the form of a multiple-layer foil, the outer layers having a lower melting point may have a thickness in the range between 20 micrometers and 500 micrometers, preferably between 20 micrometers and 200 micrometers, for example in the range between 20 micrometers and 100 micrometers or between 20 micrometers and 60 micrometers, such as in the order of 40 micrometers. The layer or layer stack sandwiched in between the outer layers, the layer or layer stack having preferably a higher melting temperature, may have a thickness in the range between 10 micrometers and 460 micrometers, for example in the range between 10 micrometers and 300 micrometers or between 10 micrometers and 100 micrometers, such as in the order of 25 micrometers.

In embodiments wherein the first part or the second part of the assembly is provided for contacting a photovoltaic cell at a cell surface intended for receiving incoming light during its operation, the respective first electrically insulating foil or second electrically insulating foil is optically transparent at least in a wavelength range to which the photovoltaic cell to be contacted is sensitive, in other words at least in a wavelength range that can be optically absorbed by the semiconductor material of the photovoltaic cell to be contacted. In such embodiments the electrically insulating foil may also be transparent to ultraviolet, UV, light, which may be advantageous when the assembly is used for electrically contacting and electrically connecting photovoltaic cells that are sensitive to light in the UV range. In embodiments both the first electrically insulating foil and the second electrically insulating foil are optically transparent, which is advantageous that such assembly is suitable for electrically contacting and electrically connecting bifacial photovoltaic cells, wherein both photovoltaic cell surfaces are intended for receiving incoming light during their operation. In embodiments wherein the first electrically insulating foil and the second electrically insulating foil are provided for contacting a photovoltaic cell at a cell surface not intended for receiving incoming light during its operation both foils may be optically non-transparent.

The plurality of electrically conductive wires is arranged over the first electrically insulating foil and over the second electrically insulating foil in a wire direction. In embodiments the wire direction may be the same direction as the first direction. Alternatively, the plurality of electrically conductive wires may be arranged in a wire direction slightly deviating from the first direction. For example, the plurality of electrically conductive wires may be provided in a wire direction, slanted wire direction, oriented at an angle of 10 degrees or less, for example 5 degrees or less with respect to the first direction. It is an advantage of providing the plurality of electrically conductive wires in such slanted wire direction that the risk of electrical shunting of a photovoltaic cell, in particular electrical shunting at lateral photovoltaic cell edges, in particular lateral photovoltaic cell edges oriented along the second direction, can be reduced or avoided. Undesired shunting of a photovoltaic cell at these edges may for example occur during an encapsulation process used for fabricating photovoltaic modules containing an assembly of the present disclosure. Such encapsulation process typically involves heating and pressing, which may result in solder material flowing along an electrically conductive wire towards a lateral edge of an electrically insulating foil of the assembly and towards a lateral edge of a photovoltaic cell connected therewith. This may result in an accumulation of solder material near edges of photovoltaic cells electrically connected therewith. The accumulated solder material may form an undesired electrical connection between electrical contacts at opposite surfaces, opposite cell surfaces, of a photovoltaic cell. By providing the plurality of electrically conductive wires in a slanted wire direction different from the first direction this risk can be substantially reduced.

The number or electrically conductive wires may for example be in the range between 10 and 50, preferably in the range between 15 and 30. The plurality of electrically conductive wires may be provided with a pitch in the order of 3 mm to 30 mm, such as a pitch in the range between 5 mm and 15 mm therein between. The plurality of electrically conductive wires may be evenly spaced or unevenly spaced. The electrically conductive wires may have a cross-sectional area in the range between 0.002 mm² and 0.2 mm², for example a diameter in the range between 50 micrometers and 400 micrometers. Other dimensions are possible. Selection of the wire cross-sectional area or the wire diameter may depend on the type of photovoltaic cells to be electrically contacted and electrically connected by the assembly. For example, in an assembly for electrically contacting and electrically connecting CIGS photovoltaic cells a smaller wire cross-sectional area or a smaller wire diameter may be selected as compared to an assembly intended for electrically contacting and electrically connecting silicon photovoltaic cells.

In an assembly of the first aspect the plurality of electrically conductive wires is locally attached to the first electrically insulating foil and to the second electrically insulating foil at predetermined locations, predetermined attachment locations, without penetrating therethrough. Local attachment can for example comprise attachment by means of an adhesive or a glue or by sticking.

In embodiments at least part of the plurality of electrically conductive wires comprises at least one bend or curvature, such as for example a loop, an indentation, a recess, at predetermined locations, predetermined bend locations, meaning that they are locally bended or curved at the predetermined bend locations and that they are not straight over their entire length. This is advantageous in that these bends or curvatures can function as stress relief structures, mitigating stress, such as for example undesired mechanical stress or thermal stress.

Such undesired stress may for example occur during subsequent process steps performed to fabricate the assembly and may for example be related to differences in thermal expansion between the electrically conductive wires and the electrically insulating foils. The stress relief effect of the plurality of electrically conductive wires being locally curved enables obtaining an assembly that is stable, stress-free, and substantially flat, non-warped. This is advantageous in that it facilitates automated handling of the assembly, for example when using the assembly in a process for electrically contacting and electrically connecting photovoltaic cells, such as in an industrial fabrication process making use of pick and place equipment.

Such undesired stress may further also refer to stress on the electrical contacts and electrical connections between the plurality of electrically conductive wires and electrical contacts of the photovoltaic cells when using the assembly in a method for electrically contacting and electrically connecting photovoltaic cells. Such stress may for example arise during thermal cycles used in a method for fabricating a photovoltaic module, for example during lamination, or during use of such photovoltaic modules. It is an advantage of the stress relief effect of the plurality of electrically conductive wires being locally curved that undesired stress on these electrical connections can be alleviated, resulting in an improved reliability thereof.

In preferred embodiments the at least one curvature is an out-of-plane curvature, meaning a curvature in a non-parallel direction with respect to the surface of the assembly. In such embodiments the electrically conductive wire is preferably locally embedded in the first electrically insulating foil and/or in the second electrically insulating foil at the predetermined bend locations. In advantageous embodiments predetermined bend locations coincide with predetermined attachment locations.

At least part of the predetermined attachment locations and/or at least part of the predetermined bend locations may be shifted with respect to each other in the first direction, between respective electrically conductive wires. For example, in such embodiments at least part of the predetermined attachment and/or bend locations may be arranged along slanted lines with respect to the first direction. It is an advantage of such arrangement that, when the assembly is used for establishing an electrical connection between the electrically conductive wires and electrical contacts of a photovoltaic cell, a more reliable electrical connection can be obtained.

The electrical contacts of a photovoltaic cell to be contacted by the assembly may comprise or consist of parallel oriented electrically conductive lines, contact fingers. When establishing electrical contacts or connections between the contact fingers and the electrically conductive wires of the assembly, these contact fingers are usually oriented substantially orthogonal to the wire direction. Therefore, by using an arrangement wherein predetermined attachment locations and in particular predetermined bend locations are shifted with respect to each other between respective electrically conductive wires, the risk of missing contact fingers, which could occur at a bend location, can be reduced and thus undesired electrical losses may be avoided. The contact fingers may for example comprise or consist of a metal, but other electrically conductive materials may be used, such as carbon or graphene-based materials. In the further description reference is only made to metal contacts, metal lines or metal fingers, but the disclosure is not limited thereto.

In an assembly of the first aspect, the electrically conductive wires penetrate neither through the first electrically insulating foil nor through the second electrically insulating foil. It is an advantage that this enables relatively fast and easy fabrication of the assembly. Although the electrically conductive wires penetrate through none of the electrically insulating foils, they may pass from one side, one surface, of the assembly to an opposite side, opposite surface, of the assembly in between the first electrically insulating foil and the second electrically insulating foil.

In an assembly of the first aspect the plurality of electrically conductive wires is exposed at both opposite sides, opposite surfaces, of the assembly, which is advantageous in that the assembly can be contacted electrically at both opposite sides.

In an assembly of the first aspect different arrangements of the first electrically insulating foil and the second electrically insulating foil are possible. For example, in embodiments both electrically insulating foils may be arranged next to each other with a predetermined gap or distance therein between in the first direction, in other words: without overlap there in between in the first direction. The predetermined gap or distance may be in the range between substantially zero and several mm or cm. In alternative embodiments the first electrically insulating foil and the second electrically insulating foil may be arranged with a predetermined overlap therein between. It is a particular advantage of an arrangement with an overlap between the first electrically insulating foil and the second electrically insulating foil that it provides an improved integrity and consistency to the assembly, resulting in easier handling of the assembly. It is a further advantage of such embodiments with overlapping electrically insulating foils that, when using the assembly for electrically contacting and electrically connecting photovoltaic cells, the risk of electrical shunting between neighbouring photovoltaic cells is reduced.

The different arrangements of the first electrically insulating foil and the second electrically insulating foil further advantageously enable easy customization of the assembly and consequently easy customization of photovoltaic devices and systems comprising the assembly. For example, it enables customizing a spacing between neighbouring photovoltaic cells in a photovoltaic module. It also enables photovoltaic module designs with overlapping photovoltaic cells.

According to a second aspect the present disclosure provides a method for fabricating an assembly for electrically contacting and electrically connecting photovoltaic cells. The method of the second aspect comprises providing a first electrically insulating foil and providing a second electrically insulating foil, arranging the first electrically insulating foil and the second electrically insulating foil relative to each other in respective positions that are laterally shifted in a first direction, and providing a plurality of electrically conductive wires substantially parallel to each other in a wire direction, such that the plurality of electrically conductive wires substantially extends over the first electrically insulating foil and over the second electrically insulating foil in the first direction, wherein the plurality of electrically conductive wires is arranged over a first foil surface of the first electrically insulating foil and further over a second foil surface of the second electrically insulating foil, the foil first surface and the second foil surface being located at opposite sides of the assembly, and thereafter locally attaching the plurality of electrically conductive wires to the first electrically insulating foil and to the second electrically insulating foil at predetermined locations, predetermined attachment locations, without penetrating therethrough.

In general, effects and features of the second aspect of the present disclosure are largely analogous to those described above in connection with the first aspect.

Locally attaching the plurality of electrically conductive wires to the first electrically insulating foil and to the second electrically insulating foil comprises local heating of the electrically insulating foils. Locally heating the electrically insulating foils for locally attaching the plurality of electrically conductive wires is preferably done up to a temperature at which the electrically insulating foil surface becomes sticky and below the melting temperature of the insulating foil material, in case of a multiple-layer foil below the melting temperature of the outer layers thereof. After cooling down, this results in local sticking, local adhesion, local attachment of the electrically conductive wires to the electrically insulating foil. Heating may for example comprise heating to a temperature in the range between 90°C and 150°C, for example in the range between 100°C and 120°C, but other temperature ranges may be used depending on the properties of the electrically insulating foil materials used. The first electrically insulating sheet and the second electrically insulating sheet preferably comprise a thermoplastic material. It is known that a thermoplastic material softens when it approaches the melting point temperature. The stickiness of the material depends on the material used, the polymer structure and the presence of, for example, adhesion promoters.

In embodiments wherein multiple-layer foils are used comprising outer layers having a lower melting temperature than the layers in between, at least one of the outer layers is preferably composed of a thermoplastic material. In such embodiments the temperature of the heating step used for locally attaching the plurality of electrically conductive wires to the first and second electrically insulating foils can be selected such that it only affects the properties, e.g. stickiness, of the outer layers of the multiple-layer foil and leaves the properties of the layers sandwiched therein between, inner layers, unaffected. This is advantageous in that the inner layers of the multiple-layer foil may provide a good stability to the foil during the heating step.

In advantageous embodiments the heating process comprises local heating of the plurality of electrically conductive wires at the predetermined attachment locations, thereby also locally heating the electrically insulating foils. It is an advantage of locally heating the electrically insulating foils indirectly, through local heating of the plurality of electrically conductive wires, that it may result in an easier and improved manufacturability as compared to locally heating the electrically insulating foils directly.

It is an advantage of local heating of the electrically conductive wires, as compared to entire heating of the wires over their full length, that it results in a reduced thermal expansion of the wires and therefore reduced thermal stress, thereby avoiding undesired warping of the assembly after cooling down. Due to the large difference between the coefficient of thermal expansion, CTE, of the wire material and the CTE of the foil material, which is typically a factor of 4 to 6 larger than the CTE of the wire material, entire heating of the wires over their full length would result in warping of the assembly upon cooling down. Warping complicates automated handling of the assembly, for example when using the assembly in a process for electrically contacting and electrically connecting photovoltaic cells, e.g., making use of pick and place equipment.

In embodiments wherein at least part of the plurality of electrically conductive wires is locally embedded in the first electrically insulating foil and/or in the second electrically insulating foil, locally attaching may comprise locally pressing the electrically conductive wires into the electrically insulating foil, thereby creating a curvature, such as for example a loop, an indentation, a recess, in the electrically conductive wires at predetermined bend locations. Locally embedding, for example by pressing, and locally attaching, by locally heating, the plurality of electrically conductive wires may be done sequentially, in separate steps. In preferred embodiments locally embedding, for example by pressing, and locally attaching by locally heating the plurality of electrically conductive wires may be done simultaneously. In embodiments wherein the heating process comprises locally heating he plurality of electrically conductive wires at the predetermined attachment locations and simultaneously locally embedding the plurality of electrically conductive wires at the predetermined bend locations, heated bars or heated pins may be used for pressing and heating.

In embodiments of the second aspect, providing the first and second electrically insulating foils comprises providing both foils in a second direction substantially orthogonal to the first direction. Providing the first electrically insulating foil may comprise unrolling a first roll of electrically insulating material in the second direction and/or providing the second electrically insulating foil may comprise unrolling a second roll of electrically insulating material in the second direction. This is advantageous in that it enables high-throughput fabrication in an industrial production environment.

In embodiments wherein an electrically insulating foil is provided by unrolling a roll of electrically insulating material, a method of the second aspect further comprises the step of cutting the roll to thereby separate the electrically insulating foil from the roll of electrically insulating material. The step of cutting the roll may be done either before locally attaching the plurality of electrically conductive wires to the electrically insulating foil, or it may alternatively be done afterwards.

In embodiments of the second aspect, providing the plurality of electrically conductive wires substantially parallel to each other in a wire direction may comprise unrolling or unwinding the electrically conductive wires, such as unrolling from a wire bobbin, preferably from a plurality of wire bobbins. Each of the plurality of electrically conductive wires may be unrolled from a separate, individual bobbin. Alternatively, two or more electrically conductive wires may be unrolled form a same bobbin. A plurality of individual bobbins may for example be provided on a bobbin rack. In embodiments of a method of the second aspect the plurality of electrically conductive wires is unrolled in a wire direction corresponding to the first direction. In alternative embodiments of the second aspect the plurality of electrically conductive wires is unrolled in a wire direction that slightly deviates from the first direction. For example, the plurality of electrically conductive wires may be unrolled in a wire direction, slanted direction, oriented at an angle of 10 degrees or less, for example 5 degrees or less with respect to the first direction.

In embodiments wherein the plurality of electrically conductive wires is unrolled from a roll or a bobbin, a method of the second aspect further comprises cutting the plurality of electrically conductive wires after their local attachment to the first electrically insulating foil and to the second electrically insulating foil.

According to a third aspect the present disclosure provides a photovoltaic device comprising an assembly according to the first aspect.

In general, effects and features of the third aspect of the present disclosure are largely analogous to those described above in connection with the first and second aspects.

According to a fourth aspect the present disclosure provides a method for electrically connecting a first photovoltaic cell comprising a plurality of first electrical contacts at a first surface, first cell surface, of the first photovoltaic cell to a second photovoltaic cell comprising a plurality of second metal contacts at a second surface, second cell surface, of the second photovoltaic cell by means of a first assembly according to the first aspect. The method of the fourth aspect comprises providing the first assembly, positioning and placing the first photovoltaic cell on the first foil surface of the first electrically insulating foil of the first assembly, with at least one first metal contact, preferably a plurality of first metal contacts, of the first photovoltaic cell in physical contact with at least one electrically conductive wire of the first assembly, and positioning and placing the second photovoltaic cell on the second foil surface of the second electrically insulating foil of the first assembly, with at least one second contact, preferably a plurality of second metal contacts, of the second photovoltaic cell in physical contact with at least one electrically conductive wire. At least one electrically conductive wire of the first assembly is a common wire, being a wire that is in physical contact with both a first metal contact of the first photovoltaic cell and with a second metal contact of the second photovoltaic cell. The method of the fourth aspect further comprises performing a heating process, thereby establishing an electrical connection between the at least one first metal contact of the first photovoltaic cell and the at least one electrically conductive wire in physical contact therewith and establishing an electrical connection between the at least one second metal contact of the second photovoltaic cell and the at least one electrically conductive wire in physical contact therewith, thereby consequently establishing an electrical connection between the first photovoltaic cell and the second photovoltaic cell through the at least one common wire of the first assembly.

In general, effects and features of the fourth aspect are largely analogous to those described above in connection with the previous aspects.

According to a fifth aspect the present disclosure provides a method for fabricating a photovoltaic device comprising a plurality of photovoltaic cells. The method of the fifth aspect comprises electrically connecting the plurality of photovoltaic cells using a method according to the fourth aspect. The method of the fifth aspect may further comprise performing an encapsulation process to thereby form an encapsulated photovoltaic module.

In general, effects and features of the fifth aspect are largely analogous to those described above in connection with the previous aspects.

Particular and preferred aspects of the disclosure are set out in the accompanying independent and dependent claims.

### Brief description of the drawings

The above, as well as additional objects, characteristics, features and advantages of the present disclosure will become apparent and will be better understood from the following illustrative and non-limiting detailed description, with reference to the appended drawings.
Fig. 1A schematically illustrates a top view of an assembly according to an embodiment of the first aspect of the disclosure.
Fig. 1B schematically shows a cross section along line A-A' of the assembly illustrated in Fig. 1A.
Fig. 1C schematically shows a cross section along line B-B' of the assembly illustrated in Fig. 1A.
Fig. 2 schematically illustrates a cross section of a photovoltaic device comprising a first photovoltaic cell and a second photovoltaic cell electrically contacted and electrically connected by means of an assembly of Fig. 1A, at the location of an electrically conductive wire. Fig. 2 further shows an enlarged view of a part of the cross section delineated by a dashed rectangle.
Fig. 3 schematically shows an example of a surface of a photovoltaic cell comprising a plurality of electrical contacts consisting of a plurality of substantially parallel contact fingers.
Fig. 4 schematically illustrates a cross section of an assembly according to an embodiment of the first aspect of the disclosure, wherein the first electrically insulating foil and the second electrically insulating foil are arranged next to each other with a gap there in between.
Fig. 5 schematically illustrates a cross section of a photovoltaic device comprising a first photovoltaic cell and a second photovoltaic cell electrically contacted and electrically connected by means of an assembly of Fig. 4.
Fig. 6 schematically illustrates a cross section of an assembly according to an embodiment of the first aspect of the disclosure, wherein the first electrically insulating foil and the second electrically insulating foil are arranged next to each other with an overlap there in between.
Fig. 7 schematically illustrates a cross section of a photovoltaic device comprising a a first photovoltaic cell and a second photovoltaic cell electrically contacted and electrically connected by means of an assembly of Fig. 6.
Fig. 8 schematically illustrates a top view of an assembly according to the first aspect wherein part of the predetermined attachment locations is shifted with respect to each other in the first direction, in the example shown arranged along slanted lines with respect to the first direction.

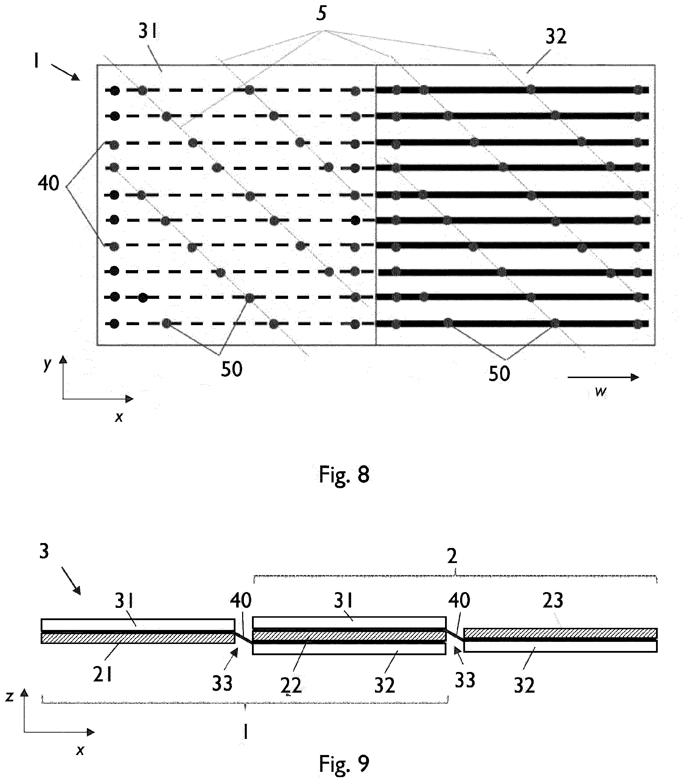

Fig. 9 schematically illustrates a cross section of a photovoltaic device comprising a first, a second and a third photovoltaic cell, wherein the first photovoltaic cell and the second photovoltaic cell are electrically contacted and electrically connected by means of a first assembly of the first aspect and wherein the second photovoltaic sell and the third photovoltaic cell are further electrically contacted and electrically connected by means of a second assembly of the first aspect. In the example shown the first electrically insulating foil and the second electrically insulating foil of both assemblies are arranged with a gap there in between.

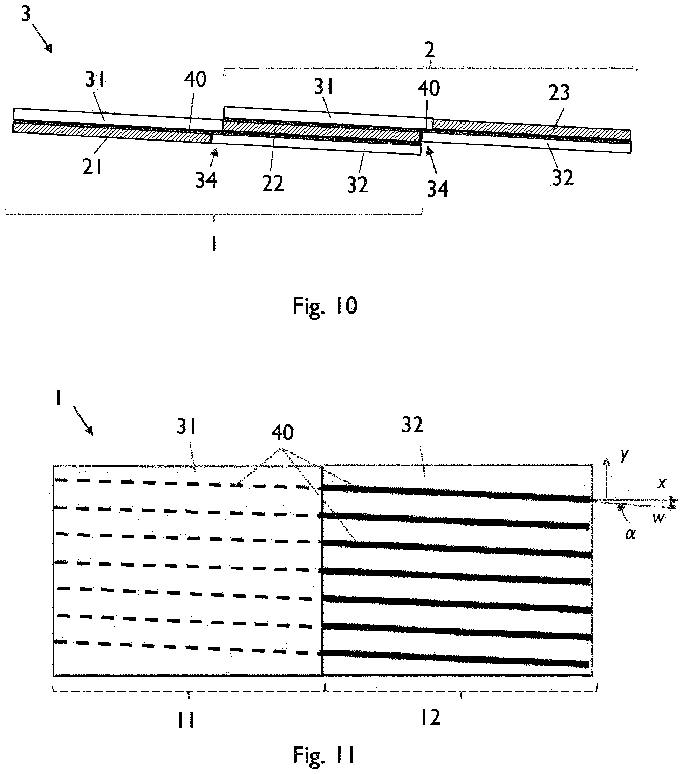

Fig. 10 schematically illustrates a cross section of a photovoltaic device comprising a first, a second and a third photovoltaic cell, wherein the first photovoltaic cell and the second photovoltaic cell are electrically contacted and electrically connected by means of a first assembly of the first aspect and wherein the second photovoltaic cell and the third photovoltaic cell are further electrically contacted and electrically connected by means of a second assembly of the first aspect. In the example shown the first electrically insulating foil and the second electrically insulating foil of both assemblies are arranged with an overlap there in between.
Fig. 11 schematically shows an example (top view) of an assembly of the first aspect wherein the plurality of electrically conductive wires is arranged in a slanted wire direction.
Fig. 12 illustrates an example (top view) of a photovoltaic device comprising a photovoltaic cell electrically contacted at a first surface by a first assembly and at a second surface by a second assembly, both assemblies having a plurality of electrically conductive wires arranged in a slanted wire direction.
Fig. 13 shows a cross-section of the photovoltaic device of Fig. 12, along line *C-C'.*
Fig. 14 shows a schematic block diagram summarizing a method for fabricating an assembly for electrically contacting an electrically connecting photovoltaic cells according to a second aspect.
Fig. 15 shows an example of providing the first electrically insulating foil, providing the second electrically insulating foil and arranging the first and second electrically insulating foils in laterally shifted positions with respect to each other in a method for fabricating the assembly.
Fig. 16 illustrates providing a plurality of electrically conductive wires in a method for fabricating the assembly.
Fig. 17 schematically shows a cross-section along line *D-D'* of Fig. 16.
Fig. 18, Fig. 19 and Fig. 20 illustrate an example of locally attaching the plurality of electrically conductive wires to the first and second electrically insulating foils in the method for fabricating an assembly.
Fig. 21 illustrates cutting the plurality of electrically conductive wires after their attachment to the first and second electrically insulating foils.
Fig. 22 schematically illustrates further fabrication steps.
Fig. 23 shows a schematic block diagram summarizing a method for electrically connecting a first photovoltaic cell and a second photovoltaic cell by means of the assembly of the first aspect.
Fig. 24 shows a schematic block diagram summarizing a method for fabricating a photovoltaic module.

In the different figures, the same reference signs refer to the same or analogous elements.

### Detailed description

In cooperation with attached drawings, the technical contents and detailed description of the present inventive concept are described hereinafter according to a preferable embodiment, being not used to limit the claimed scope. This inventive concept may be embodied in many different forms and should not be construed as limited to the embodiments set forth herein; rather, these embodiments are provided for thoroughness and completeness, and fully convey the scope of the inventive concept to the skilled person.

The following terms are provided solely to aid in the understanding of the disclosure.

In the context of the present disclosure the front surface or front side of a photovoltaic cell or of a photovoltaic module refers to the cell surface or side adapted for being oriented towards a light source and thus for receiving illumination. However, in case of bifacial photovoltaic cells or modules, both cell surfaces are adapted to receive impinging light. In such case, the front surface or front side is the cell surface or side adapted for receiving the largest fraction of the light or illumination. The back surface, rear surface, back side or rear side of a photovoltaic cell or a photovoltaic module is the cell surface or side opposite to the front surface or side.

In the context of the present disclosure a busbar refers to an electrically conductive strip for collecting an electrical current, e.g. a current generated under illumination, from a plurality of metal contacts provided on a surface of a photovoltaic cell. A busbar is provided for direct electrical connection with an external electrical lead. A busbar typically collects the current from finer or narrower metal contacts, also called metal fingers, on the cell. These finer or narrower metal contacts collect current from the cell and deliver the current to the busbars; they are typically not provided for direct electrical connection to an external electrical lead.

In the context of the present disclosure a busbar-free photovoltaic cell is a photovoltaic cell not having busbars. A busbar-free photovoltaic cell may typically comprise a plurality of metal contacts on a surface of the cell, but it does not comprise an electrically conductive element for collecting current from the plurality of metal contacts.

In the context of the present disclosure, the term 'wire' refers to an elongate element that has a wire-like form or shape. For example, it may refer to a thread, a wire, a filament, a strand, a ribbon, a strip, a tape, a rod, a tubular structure or a similar elongate element.

The disclosure will now be described by a detailed description of several embodiments of the disclosure. It is clear that other embodiments of the disclosure can be configured according to the knowledge of persons skilled in the art without departing from the technical teaching of the disclosure, the disclosure being limited only by the terms of the appended claims.

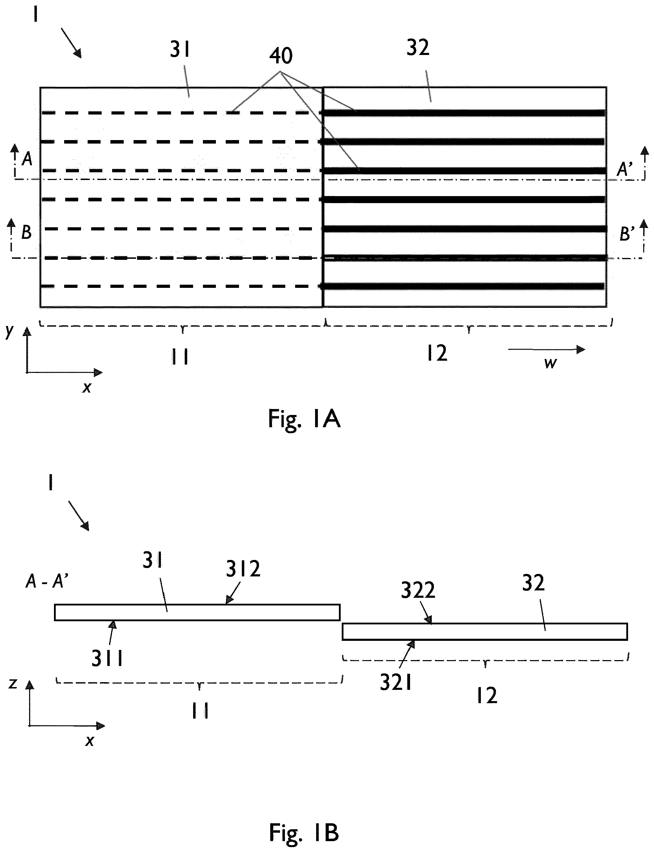

Fig. 1A schematically illustrates a top view of an assembly 1 according to an embodiment of the first aspect of the disclosure. The assembly comprises a first part 11 comprising a first electrically insulating foil 31 and a second part 12 comprising a second electrically insulating foil 32. The first electrically insulating foil 31 and the second electrically insulating foil 32 are arranged side by side, in respective positions that are laterally shifted in a first direction *x.* In the example shown the first electrically insulating foil 31 and the second electrically insulating foil 32 are positioned directly next to each other, with a substantially zero gap therein between in the first direction *x,* without overlap therein between. The assembly 1 further comprises a plurality of electrically conductive wires 40 arranged substantially parallel to each other in a wire direction *w.* In the example shown the plurality of electrically conductive wires 40 completely extends over both electrically insulating foils, meaning that they extend between opposite lateral sides of the assembly 1. In embodiments the plurality of electrically conductive wires 40 may extend over a part of both electrically insulating foils, preferably over a substantial part of both electrically insulating foils, in other words: the plurality of electrically conductive wires may substantially extend over both electrically insulating foils. In embodiments the plurality of electrically conductive wires 40 may extend completely over both electrically insulating foils, between opposite lateral sides of the assembly 1 and extend further, beyond the opposite lateral sides of the assembly 1.

Fig. 1B schematically shows a cross section along line A-A' of the assembly 1, at a location in between two electrically conductive wires. The first electrically insulating foil 31 has a first foil surface 311 and a second foil surface 312 opposite to the first foil surface 311. Likewise, the second electrically insulating foil 32 has a first foil surface 321 and a second foil surface 322 opposite to the first foil surface 321. In the example shown the first foil surface 311 of the first electrically insulating foil 31 is substantially aligned with the second foil surface 322 of the second electrically insulating foil 32 at their facing foil edges. However, the disclosure is not limited thereto. For example, in embodiments the first foil surface 311 of the first electrically insulating foil may be substantially aligned with the first foil surface 321 of the second electrically insulating foil 32, and the plurality of electrically conductive wires 40 may be bended in an area between the first electrically insulating foil 31 and the second electrically insulating foil 32 (not illustrated). For example, in embodiments there may be a gap between the first foil surface 311 of the first electrically insulating foil 31 and the second foil surface 322 of the second electrically insulating foil 32 in a third direction z orthogonal to the *x-y* plane of the first and second foil surfaces. An example of such embodiment is further described and shown in Fig. 9.

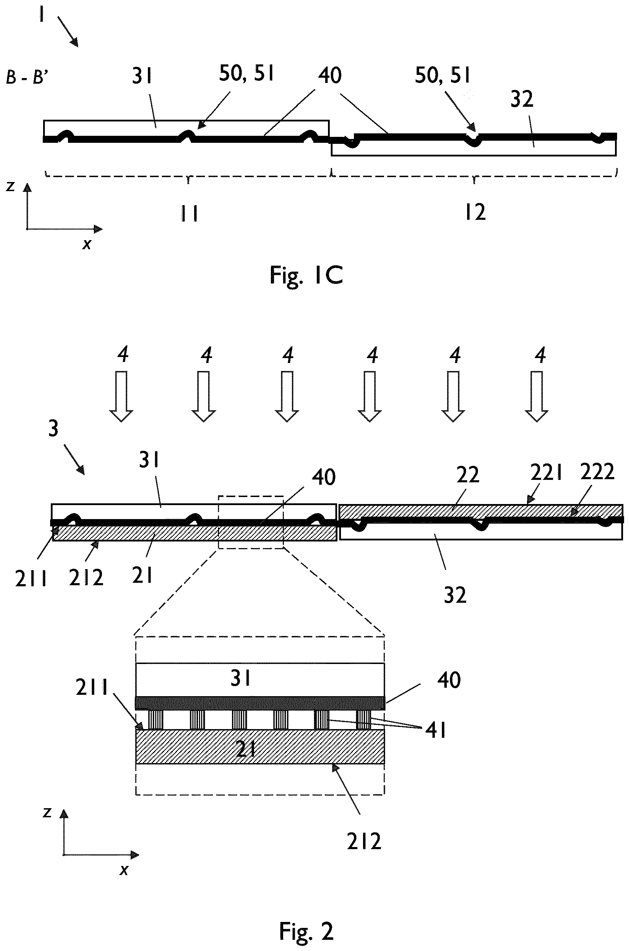

Fig. 1C schematically shows a cross section along line B-B' of the assembly 1, at a location where an electrically conductive wire 40 is arranged on the first foil surface 311 of the first electrically insulating foil 31 and further on the second foil surface 322 of the second electrically insulating foil 32. As illustrated in Fig. 1B, the first foil surface 311 of the first electrically insulating foil 31 and the second foil surface 322 of the second electrically insulating foil 32 are located at opposite sides of the assembly 1, meaning that they are located at opposite sides of the assembly 1 in third direction z orthogonal to the x-y plane of the first and second foil surfaces. The plurality of electrically conductive wires 40 is locally attached to the first electrically insulating foil 31 and to the second electrically insulating foil 32 at predetermined locations 50, predetermined attachment locations 50, without penetrating through any of the electrically insulating foils.

In the example illustrated in Fig. 1C the electrically conductive wire 40 comprises a bend, a curvature, an indentation, a recess, a loop, at the predetermined attachment locations 50. The electrically conductive wire 40 is thus locally embedded in the first electrically insulating foil 31 and in the second electrically insulating foil 32 at predetermined bend locations 51, in the example shown coinciding with the predetermined attachment locations 50. In the example of Fig. 1C the electrically conductive wire 40 is embedded in the first electrically insulating foil 31 and in the second electrically insulating foil 32 at all predetermined attachment locations 50. The disclosure is however not limited thereto. For example, the plurality of electrically conductive wires 40 may be embedded at predetermined bend locations 51 corresponding to part of the predetermined attachment locations 50 (not illustrated) instead of at all predetermined attachment locations 50.

In an assembly 1 of the present disclosure wherein the first part 11 is provided for contacting a photovoltaic cell at a cell surface intended for receiving incoming light during its operation, the first electrically insulating foil 31 is optically transparent at least in a wavelength range to which the photovoltaic cell is sensitive. Likewise, in an assembly 1 of the present disclosure wherein the second part 12 is provided for contacting a photovoltaic cell at a cell surface intended for receiving incoming light during its operation, the second electrically insulating foil 32 is optically transparent at least in a wavelength range to which the photovoltaic cell is sensitive.

Fig. 2 schematically illustrates a cross section of a photovoltaic device 3 comprising a first photovoltaic cell 21 and a second photovoltaic cell 22 electrically contacted and electrically connected by means of an assembly 1 as shown in Fig. 1A and Fig. 1C, at the location of an electrically conductive wire 40. Fig. 2 includes an enlarged view of a part of the cross section delineated by a dashed rectangle. The first photovoltaic cell 21 and the second photovoltaic cell 22 comprise at least one electrical contact, preferably a plurality of electrical contacts, at a cell surface facing the assembly 1. In the example shown the first photovoltaic cell 21 comprises a plurality of first metal contacts 41 at a first cell surface 211, as illustrated in the enlarged view of Fig. 2. The first photovoltaic cell 21 may further comprise at least one electrical contact (not shown) at a second cell surface 212 opposite to the first cell surface 211. Similar to the first photovoltaic cell 21, the second photovoltaic cell 22 comprises a plurality of second metal contacts 42, second electrical contacts (not shown), at a second cell surface 222, and it may further comprise at least one first metal contact (not shown) at a first cell surface 221. In the enlarged view of Fig. 2 a part of the plurality of electrical contacts 41 of the first photovoltaic cell 21 at the first cell surface 211 is schematically shown. The first cell surface 211 of the first photovoltaic cell 21 is facing the first foil surface 311 of the first electrically insulating foil 31 and is in physical contact therewith. At least one first electrical contact 41, preferably the plurality of first electrical contacts 41, of the first photovoltaic cell 21 is in electrical contact with at least one electrically conductive wire 40 of the assembly 1. Similarly, the second cell surface 222 of the second photovoltaic cell 22 is facing the second foil surface 322 of the second electrically insulating foil 32 and is in physical contact therewith. The second photovoltaic cell 22 has second electrical contacts 42 (not illustrated) at the second cell surface 222 facing the second electrically insulating foil 32. At least one second electrical contact 42, preferably the plurality of second electrical contacts 42, of the second photovoltaic cell 22 is in electrical contact with at least one electrically conductive wire 40 that is also in electrical contact with a first electrical contact 41 of the first photovoltaic cell 21. Thus, at least one electrically conductive wire 40 is a common wire, meaning an electrically conductive wire 40 that is in electrical contact with both a first metal contact 41 of the first photovoltaic cell 21 and a second metal contact 42 of the second photovoltaic cell 22, such that the second photovoltaic cell 22 is electrically connected to the first photovoltaic cell 21 through the at least one common wire 40 of the assembly.

In the example shown in Fig. 2 the first cell surface 211 of the first photovoltaic cell 21 and the second cell surface 222 of the second photovoltaic cell 22 are considered as light-receiving cell surfaces, intended for receiving incoming light 4 during their operation. As the first electrically insulating foil 31 is located at a light receiving side of the first photovoltaic cell 21, the first electrically conductive foil 31 is optically transparent at least in a wavelength range to which the first photovoltaic cell 21 is sensitive. In this example, the second electrically insulating foil 32 is assumed to be located at a side of the second photovoltaic cell 22 not intended for receiving light. Therefore, the second electrically insulating foil 32 may be optically non-transparent or optically transparent.

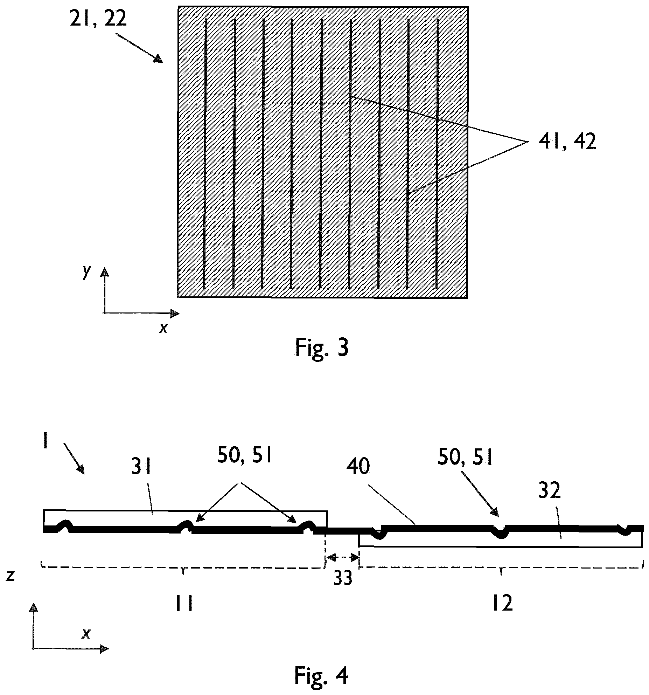

The plurality of first electrical contacts 41 and/or the plurality of second electrical contacts 42 may comprise a plurality of substantially parallel metal lines, e.g. consist of a plurality of substantially parallel metal lines, contact fingers, oriented in a direction different from the first direction *x,* for example oriented substantially along second direction *y,* orthogonal to the first direction *x.* This is schematically illustrated in Fig. 3, showing an example of a surface, cell surface, of a photovoltaic cell 21, 22 comprising a plurality of electrical contacts 41, 42 consisting of a plurality of substantially parallel contact fingers provided in the second direction *y,* substantially parallel to lateral edges of the photovoltaic cell 21, 22. Other electrical contact configurations may be used. For example, the plurality of electrical contacts may comprise interrupted lines and/or the plurality of electrical contacts may be provided in a direction different from the second direction y, such as a diagonal direction.

Fig. 4 schematically illustrates a cross section of an assembly 1 according to an embodiment of the first aspect of the disclosure, at a location where an electrically conductive wire 40 is arranged on the first foil surface 311 of the first electrically insulating foil 31 and further on the second foil surface 322 of the second electrically insulating foil 32. In the example shown in Fig. 4 the first electrically insulating foil 31 and the second electrically insulating foil are arranged next to each other with a predetermined gap 33 there in between in the first direction x.

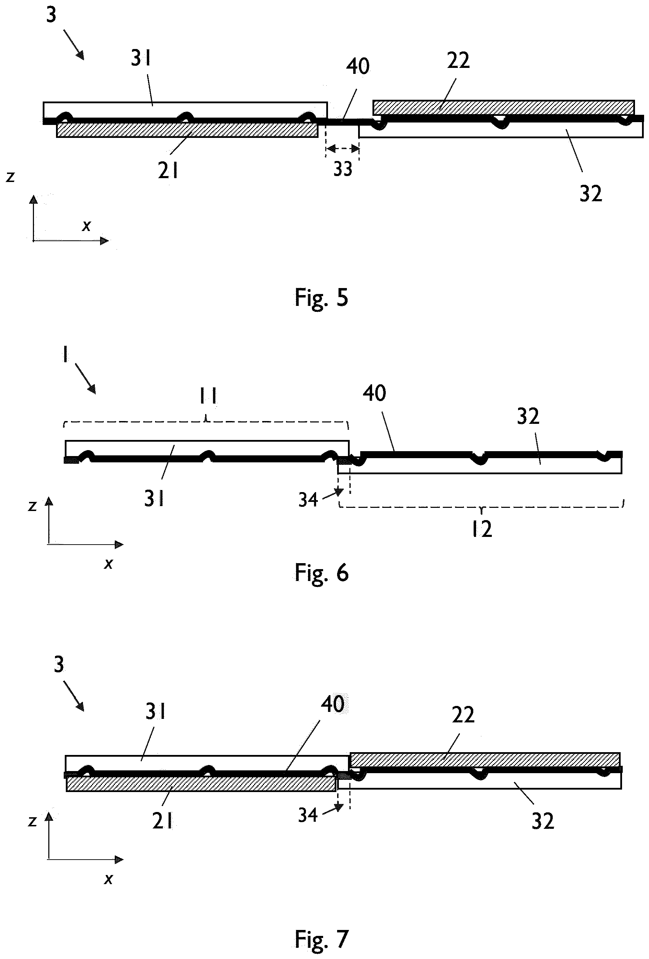

Fig. 5 schematically illustrates a photovoltaic device 3 comprising a first photovoltaic cell 21 and a second photovoltaic cell 22 electrically contacted and electrically connected by means of an assembly of Fig. 4.

It is an advantage of arranging the first electrically insulating foil 31 and the second electrically insulating foil next to each other with a predetermined gap 33 there in between that the plurality of electrically conductive wires 40 can be accommodated in the space provided by the gap. It is a further advantage of such arrangement that the plurality of electrically conductive wires 40 can be bended (not illustrated) within the gap area, wherein the bending of the wires may relief stress. It is a further advantage of arranging the first electrically insulating foil 31 and the second electrically insulating foil next to each other with a predetermined gap 33 there in between that in enables creating partially transparent photovoltaic devices.

Fig. 6 schematically illustrates a cross section of an assembly 1 according to an embodiment of the first aspect of the disclosure, at a location where an electrically conductive wire 40 is arranged on the first foil surface 311 of the first electrically insulating foil 31 and further on the second foil surface 322 of the second electrically insulating foil 32. In the example shown in Fig. 6 the first electrically insulating foil 31 and the second electrically insulating foil 32 are arranged next to each other with a predetermined overlap 34 there in between in the first direction x.

Fig. 7 schematically illustrates a photovoltaic device 3 comprising a first photovoltaic cell 21 and a second photovoltaic cell 22 electrically contacted and electrically connected by means of an assembly of Fig. 6.

It is an advantage of arranging the first electrically insulating foil 31 and the second electrically insulating foil 32 with an overlap 34 there in between that the assembly has an improved integrity and consistency, enabling easier handling of the assembly. In the region of the overlap 34 the first electrically insulating foil 31 and the second electrically insulating foil preferably adhere or stick to each other. An overlap of 100 micrometers to 200 micrometers may be sufficient to allow local sticking of the first electrically insulating foil 31 to the second electrically insulating foil 32 and enabling easier handling. However, the minimum achievable overlap may also depend on potential cutting and alignment precision restrictions.

Furthermore, due to the presence of an overlap 34 the risk of shunting at lateral photovoltaic cell edges is reduced. Undesired shunting at edges of photovoltaic cells 21, 22 that are electrically connected by means of an assembly 1 of the present disclosure may for example occur during an encapsulation process used for fabricating photovoltaic modules in a subsequent process. Such encapsulation process typically involves heating and pressing, which may result in solder material flowing along an electrically conductive wire 40 towards photovoltaic cell edges. This may result in an accumulation of solder material near the photovoltaic cell edges, creating a risk of accumulated solder material forming an undesired electrical connection between photovoltaic cells or creating an undesired electrical connection between the front side and the back side of a photovoltaic cell at a cell edge. By arranging the first electrically insulating foil 31 and the second electrically insulating foil 32 with an overlap 34 as illustrated in Fig. 6 and Fig. 7, this risk is substantially reduced.

It is a further advantage of an arrangement with an overlap 34 between both electrically insulating foils that it enables a better encapsulant filling in the area between the neighbouring photovoltaic cells 21, 22, i.e. in the area corresponding to the overlap 34. The minimum foil overlap required to obtain this advantage depends on the relative thickness of the plurality of electrically conductive wires and the first and second electrically insulating foils of the assembly, and further on the thickness of the photovoltaic cells to be electrically connected by means of the assembly. It may further depend on the rheological properties of the encapsulation material used when fabricating a photovoltaic device.

Fig. 8 schematically illustrates a top view of an assembly 1 according to an embodiment of the first aspect wherein part of the predetermined attachment locations 50 where the electrically conductive wires 40 are attached to the first electrically insulating foil 31 and to the second electrically insulating foil 32 is shifted with respect to each other in the first direction x, between respective electrically conductive wires 40. In the example shown these predetermined attachment locations 50 are arranged along slanted lines 5. Other arrangements of the predetermined attachment locations 50 may be used.

Fig. 9 schematically illustrates a cross section of a photovoltaic device 3 comprising a first photovoltaic cell 21, a second photovoltaic cell 22 and a third photovoltaic cell 23, wherein the first photovoltaic cell 21 and the second photovoltaic cell 22 are electrically contacted and electrically connected by means of a first assembly 1 of the first aspect and wherein the second photovoltaic cell 22 and the third photovoltaic cell 23 are further electrically contacted and electrically connected by means of a second assembly 2 of the first aspect. In the example shown, the first electrically insulating foil 31 and the second electrically insulating foil 32 of both assemblies 1, 2 are arranged next to each other with a gap 33 there in between. In the example shown the second photovoltaic cell 22 is common to both the first and second assembly: a first cell surface of the second photovoltaic cell 22 is in electrical contact with a first part of the second assembly 2 and a second cell surface of the second photovoltaic cell 22 is in electrical contact with a second part of the first assembly 1. This requires the presence of first electrical contacts at the first cell surface and second electrical contacts at the second cell surface as described with relation to Fig. 2. As can be seen in Fig. 9, the presence of a gap 33 is advantageous in that the plurality of electrically conductive wires 40 can be accommodated in the space provided by the gap. Preferably the size of the gap 33 in the first direction *x* is at least in the order of 1 mm to 2 mm. Larger gap sizes may be used, for example based on customer's requirements, for aesthetical reasons or for creating partially transparent devices.

In the example shown in Fig. 9, the first electrically insulating foil 21 and the second electrically insulating foil 22 of the first assembly 1 and of the second assembly 2 are arranged with a gap in the third direction *z* between the first foil surface of the first electrically insulating foil and the second foil surface of the second electrically insulating foil. By providing such a gap in the third direction *z* and bending the plurality of electrically conductive wires 40 within the gap 33, the photovoltaic cells 21, 22, 23 can be arranged next to each other in a same plane and without tilting, resulting in a substantially flat photovoltaic device 3. It is a further advantage that the plurality of electrically conductive wires 40 may be shaped within the gap in the form of a curvature, a loop or any other suitable shape such as an S-shape that can contribute to the accommodation of stress, such as thermal stress.

Fig. 10 schematically illustrates a cross section of a photovoltaic device 3 comprising a first photovoltaic cell 21, a second photovoltaic cell 22 and a third photovoltaic cell 23, wherein the first photovoltaic cell 21 and the second photovoltaic cell 22 are electrically contacted and electrically connected by means of a first assembly 1 of the first aspect and wherein the second photovoltaic cell 22 and the third photovoltaic cell 23 are further electrically contacted and electrically connected by means of a second assembly 2 of the first aspect. In the example shown the photovoltaic cell 22 is common to both the first and second assembly: a first cell surface of the second photovoltaic cell 22 is in electrical contact with a first part of the second assembly 2 and a second cell surface of the second photovoltaic cell 22 is in electrical contact with a second part of the first assembly 1. This requires the presence of first electrical contacts at the first cell surface and second electrical contacts at the second cell surface as described with relation to Fig. 2. In the example shown the first electrically insulating foil 31 and the second electrically insulating foil 32 of both assemblies 1, 2 are arranged with an overlap 34 there in between. Due to the presence of this overlap 34, there is no space in between the first assembly 1 and the second assembly 2 for accommodation of the plurality of electrically conductive wires 40 as is the case in the embodiment shown in Fig. 9. Therefore, the configuration of Fig. 10 results in a photovoltaic device 3 wherein the photovoltaic cells 21, 22, 23 are slightly tilted. The tilting angle or slope may be sufficiently small to enable proper encapsulation and lamination afterwards.

Fig. 9 and Fig. 10 illustrate a photovoltaic device 3 comprising three photovoltaic cells. It is clear that additional photovoltaic cells can be added and electrically connected in a similar way.

In advantageous embodiments the plurality of electrically conductive wires 40 is arranged in a slanted wire direction, meaning: in a wire direction *w* that slightly deviates from the first direction *x.* An example of such embodiment is schematically shown in Fig. 11, wherein the plurality of electrically conductive wires 40 is oriented along a wire direction w at an angle α with respect to the first direction *x.* The angle *α* between the wire direction w and the first direction *x* may for example be 10 degrees or less, for example 5 degrees or less.

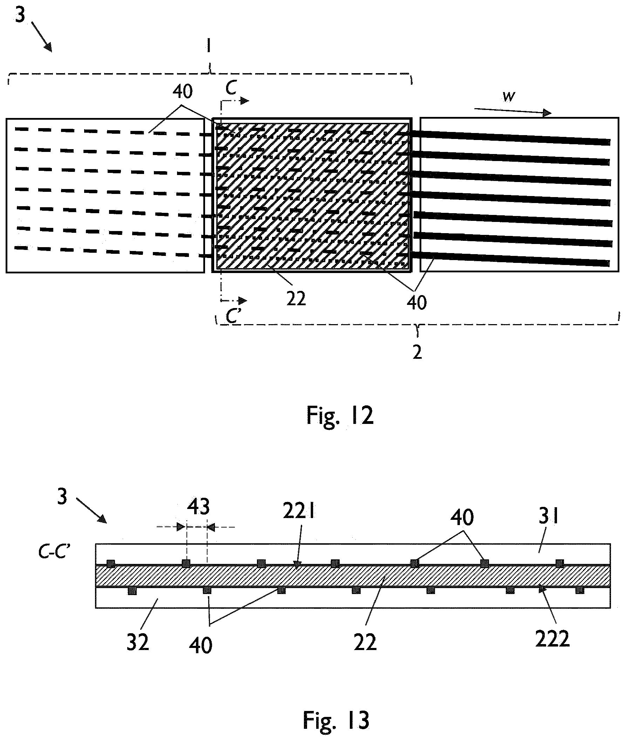

Fig. 12 illustrates an example (top view) of a photovoltaic device 3 comprising a first assembly 1 and a second assembly 2 both having a plurality of electrically conductive wires 40 arranged in a slanted wire direction *w,* as shown in Fig. 11. The drawing further illustrates a second photovoltaic cell 22 electrically contacted at the second cell surface 222 by the first assembly 1 and electrically contacted at the first cell surface 221 by the second assembly 2. The photovoltaic device 3 may comprise additional photovoltaic cells. For example, it may comprise a first photovoltaic cell 21 contacted by the first assembly 1 and electrically connected with the second photovoltaic cell 22 by means of the first assembly 1, and it may further comprise a third photovoltaic cell 23 contacted by the second assembly 2 and electrically connected with the second photovoltaic cell 22 by the means of the second assembly 2 (not illustrated in Fig. 12). For illustration purposes, the second photovoltaic cell 22 is made transparent in Fig. 12 to illustrate the relative position of the electrically conductive wires 40 of the first assembly 1 and the electrically conductive wires 40 of the second assembly 2. In Fig. 12 the electrically conductive wires 40 of the first assembly 1 are shown as dotted lines where they are in contact with the second photovoltaic cell 22, whereas the electrically conductive wires 40 of the second assembly 2 are shown as dash-dot lines where they are in contact with the second photovoltaic cell 22.

It is an advantage of providing the plurality of electrically conductive wires 40 in a slanted wire direction w that the risk of electrical shunting at edges of the photovoltaic cells 21, 22, 23, in particular at lateral edges oriented along the second direction *y,* can be reduced or avoided. This is schematically illustrated in Fig. 13, showing a cross-section of the photovoltaic device 3 of Fig. 12, along line *C-C'.* At the location of the cross-section *C-C'* the second photovoltaic cell 22 is stacked between the second electrically insulating foil 32 of the first assembly 1 and the first electrically insulating foil 31 of the second assembly 2, with a plurality of electrically conductive wires 40 between the second electrically insulating foil 32 of the first assembly 1 and the second cell surface 222 of the second photovoltaic cell 22 and with a plurality of electrically conductive wires 40 between the first electrically insulating foil 31 of the second assembly 2 and the first cell surface 321 of the second photovoltaic cell 22. By providing the plurality of electrically conductive wires 40 in a slanted wire direction *w,* as illustrated in the example, an offset 43 is created between the wires 40 at lateral edges of the second photovoltaic cell 22, between at one hand the electrically conductive wires 40 electrically connected to the first metal contacts 41 at the first cell surface 221 of the photovoltaic cell 22 and at the other hand the electrically conductive wires 40 electrically connected to the second metal contacts 42 at the second cell surface 222 of the second photovoltaic cell 22. The offset 43 substantially reduces the risk of electrical shunting of the photovoltaic cell 22 resulting from solder material flowing along the electrically conductive wires 40 during for example a lamination process.

Other approaches may be adopted for avoiding or substantially reducing such undesired shunting. For example, the first assembly 1 having electrically conductive wires 40 connected to the first cell surface of a photovoltaic cell and the second assembly 2 having electrically conductive wires connected to the second cell surface of the photovoltaic cell may have electrically conductive wires 40 oriented substantially in the first direction *x,* but with a different location of the electrically conductive wires in the second direction *y* orthogonal to the first direction *x.*

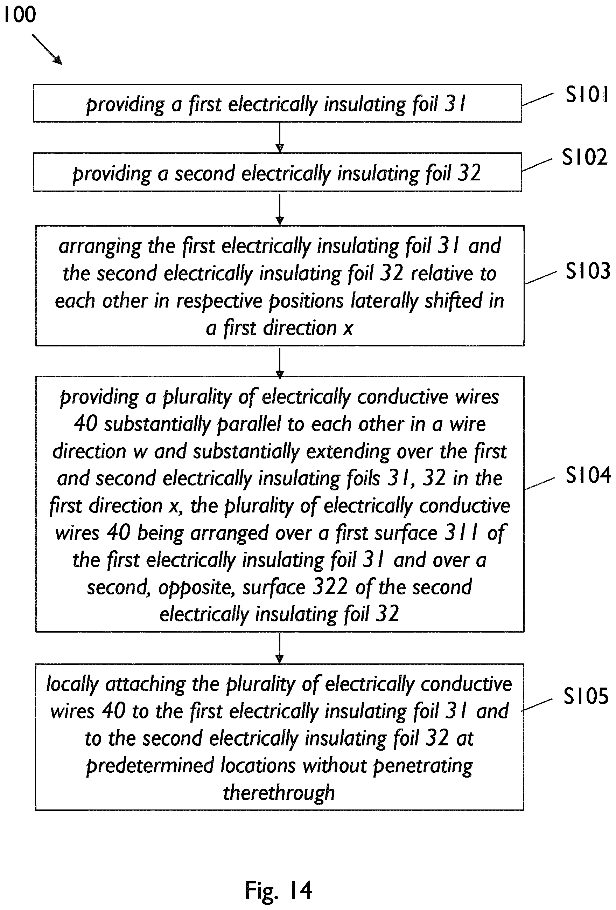

Fig. 14 shows a schematic block diagram summarizing a method 100 for fabricating an assembly for electrically contacting and electrically connecting photovoltaic cells.

The method 100 comprises providing S101 a first electrically insulating foil 31 and providing S102 a second electrically insulating foil 32.

The method 100 further comprises arranging S103 the first electrically insulating foil 31 and the second electrically insulating foil 32 relative to each other in respective positions that are laterally shifted in a first direction *x.*

The method 100 further comprises providing S104 a plurality of electrically conductive wires 40 substantially parallel to each other in a wire direction *w,* such that the plurality of electrically conductive wires 40 substantially extends over the first electrically insulating foil 31 and over the second electrically insulating foil 32 in the first direction *x,* wherein the plurality of electrically conductive wires 40 is arranged over a first foil surface 311 of the first electrically insulating foil 31 and further over a second foil surface 322 of the second electrically insulating foil 32, the first foil surface 311 and the second foil surface 322 being located at opposite sides of the assembly.

The method 100 comprises locally attaching S105 the plurality of electrically conductive wires 40 to the first electrically insulating foil 31 and to the second electrically insulating foil 32 at predetermined attachment locations 50 without penetrating therethrough.

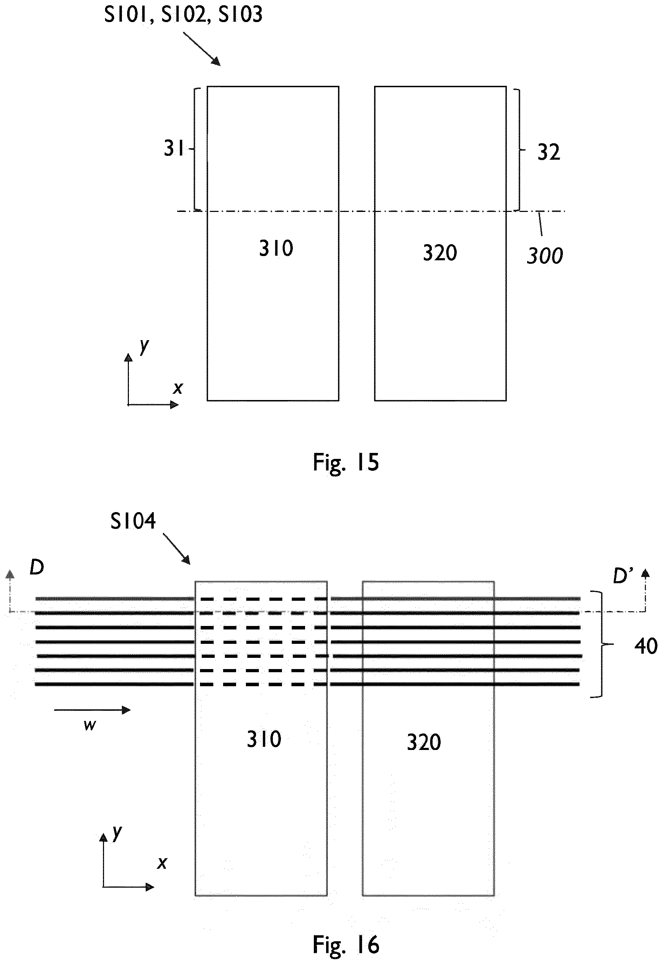

An example of a method 100 for fabricating an assembly 1, 2 for electrically contacting and electrically connecting photovoltaic cells 21, 22, 23 is illustrated in Fig. 15 to Fig. 20.

Fig. 15 shows an example of providing S101 the first electrically insulating foil 31, providing S102 the second electrically insulating foil 32 and arranging S103 the first electrically insulating foil 31 and the second electrically insulating foil 32 relative to each other in respective positions that are laterally shifted in a first direction x.

The example shown in Fig. 15 illustrates an embodiment wherein the first electrically insulating foil 31 is supplied from a first roll 310 of electrically insulating material and wherein the second electrically insulating foil 32 is supplied from a second roll 320 of electrically insulating material. This is preferably done by unrolling the first roll 310 and the second roll 320 in the second direction *y* substantially orthogonal to the first direction *x.* This embodiment is advantageous in that it enables high-throughput fabrication at low cost in an industrial environment. In a later fabrication step the first electrically insulating foil 31 may be separated from the first roll 310 of electrically insulating material, for example by cutting the electrically insulating material of the first roll 310, and the second electrically insulating foil 32 may be separated from the second roll 320 of electrically insulating material, for example by cutting the electrically insulating material of the second roll 320. This is schematically indicated in Fig. 15 by cutting line *300.* Separating the first electrically insulating foil 31 from the first roll 310 and separating the second electrically insulating foil 32 from the second roll 320 may be done either before providing S104 the plurality of electrically conductive wires 40 or afterwards. It can be done either before locally attaching S105 the plurality of electrically conductive wires 40 to the first electrically insulating foil 31 and to the second electrically insulating foil 32 or afterwards.

Fig. 16 illustrates providing S104 a plurality of electrically conductive wires 40 in a method 100 for fabricating the assembly. The plurality of electrically conductive wires 40 is provided substantially parallel to each other in a wire direction *w,* such that they extend over the first electrically insulating foil 31 and over the second electrically insulating foil 32 in the first direction x.

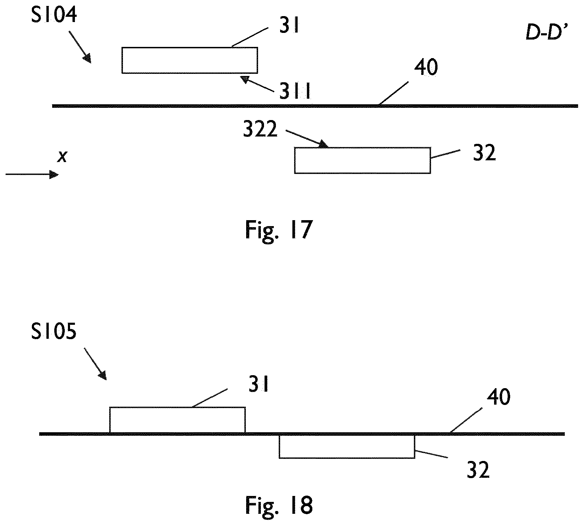

Fig. 17 schematically shows a cross-section along line *D-D'* of Fig. 16, at the location of an electrically conductive wire 40. As illustrated in Fig. 17, the plurality of electrically conductive wires 40 is arranged over a first foil surface 311 of the first electrically insulating foil 31 (dashed lines in Fig. 16) and further over a second foil surface 322 of the second electrically insulating foil 32, the first foil surface 311 and the second foil surface 322 being located at opposite sides of the assembly.

Fig. 18, Fig. 19 and Fig. 20 illustrate an example of locally attaching S105 the plurality of electrically conductive wires 40 to the first electrically insulating foil 31 and to the second electrically insulating foil 32 at predetermined attachment locations 50. In each of these figures a cross-section is shown at a location corresponding to line *D-D'* of Fig. 16.

First, as illustrated in Fig. 18, the plurality of electrically conductive wires 40 is brought into physical contact with the first electrically insulating foil 31 and with the second electrically insulating foil 32. This can for example be done by clamping the plurality of electrically conductive wires 40, the first electrically insulating foil 31 and the second electrically insulating foil 32 and moving them towards each other till they are in physical contact. Clamping the plurality of electrically conductive wires 40 may involve slightly pre-tensioning the plurality of electrically conductive wires 40 to straighten the wires 40. Excessive tension on the wires if preferably avoided because this may lead to a reduced ductility of the wire material, which is not desirable. The optimum pre-tension depends on the thickness and the material of the plurality of electrically conductive wires.

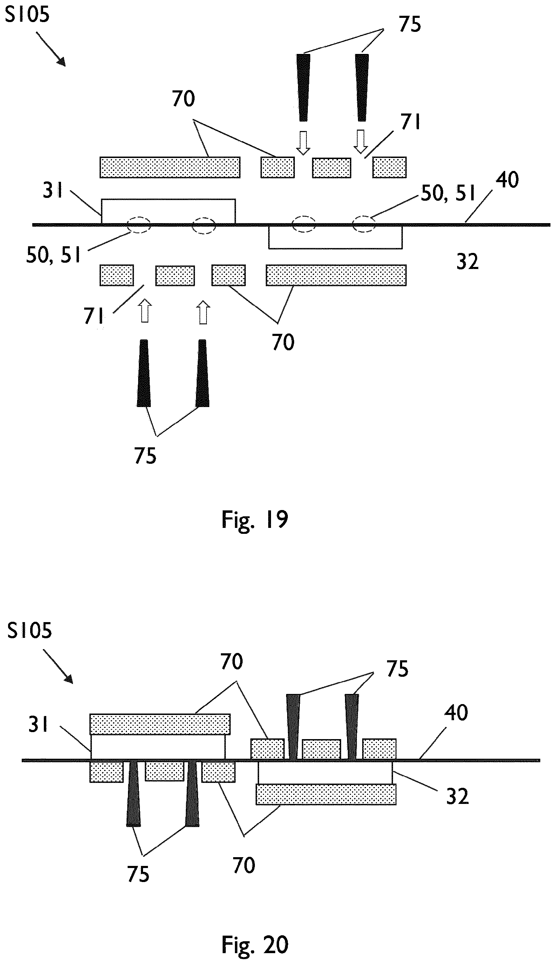

Next, the plurality of electrically conductive wires 40 is physically attached to the first electrically insulating foil 31 and to the second electrically insulating foil 32 at predetermined attachment locations 50, preferably by local heating of the plurality of electrically conductive wires 40 at the predetermined attachment locations 50. As illustrated in Fig. 19, this can for example be done by providing a mould 70 having openings 71 at locations corresponding to the predetermined attachment locations 50 and by providing heating elements 75, such as for example heating pins, through the openings 71, as indicated by the arrows in Fig. 19.

As schematically illustrated in Fig. 20, this is followed by closing the mould 70, thereby pressing the plurality of electrically conductive wires 40 against the first electrically insulating foil 31 and against the second electrically insulating foil 32 and bringing the heating elements 75 in physical contact with the plurality of electrically conductive wires 40 at the predetermined attachment locations. The heating elements 75 are heated, such that the plurality of electrically conductive wires 40 is locally heated at the predetermined attachment locations 50, such as for example to a temperature in the range between 90°C and 150°C, such as a temperature in the range between 100°C and 120°C. It is an advantage of locally heating the plurality of electrically conductive wires 40 instead of heating the wires along their entire length that thermal expansion of the plurality of electrically conductive wires 40 can be limited during the heating step, thereby also reducing stress when cooling down afterwards and thereby also avoiding warping of the assembly. This is advantageous in that a substantially flat assembly is obtained.

Heating is preferably done up to a temperature at which the foil surface of the first electrically insulating foil 31 and the foil surface of the second electrically insulating foil 32 become sticky, but below their melting temperature. Upon cooling down, this then results in local sticking, local adhesion, local attachment of the plurality of electrically conductive wires 40 to the first electrically insulating foil 31 and to the second electrically insulating foil 32 at the predetermined attachment locations 50.

Before starting the heating step or, preferably, simultaneously with the heating step a pressure may be applied to at least part of the heating elements 75 to thereby cause a local indentation of the plurality of electrically conductive wires 40 at predetermined bend locations 51, resulting in local embedding of the plurality of electrically conductive wires 40 in the first electrically insulating foil 31 and in the second electrically insulating foil 32 at the predetermined bend locations 51. The local indentations are enabled by local plastic deformation of the wires. At this stage the pre-tension on the wires may be released.

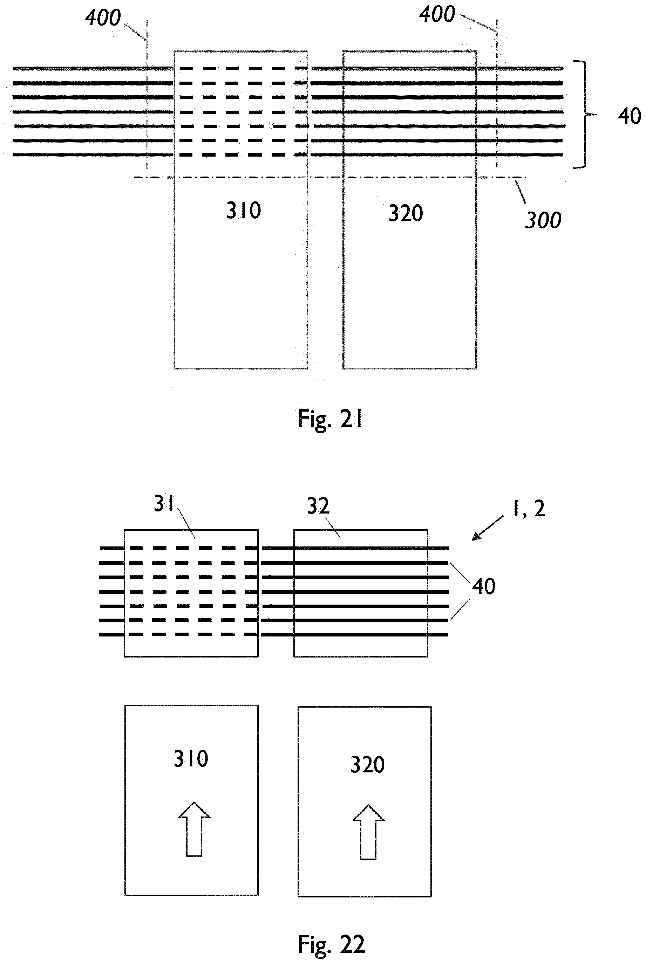

After cooling down the heating elements 75 and after opening and retracting the mould 70 and the heating elements 75 the plurality of electrically conductive wires 40 may be cut to a desired length, for example to separate them from a bobbin, along cutting lines *400* schematically shown in Fig. 21. If not yet done before, the first electrically insulating foil 31 may be separated from the first roll 310 of electrically insulating material by cutting the electrically insulating material of first roll 310, and the second electrically insulating foil 32 may be separated from the second roll 320 of electrically insulating material by cutting the electrically insulating material of the second roll 320 along cutting lines *300* schematically shown in Fig. 21.

After having performed these cutting steps, the assembly 1, 2 of the first aspect is obtained as illustrated in top part of Fig. 22. Next the first roll 310 of electrically insulating material and the second roll 320 of electrically insulating material may be further unrolled as indicated by the arrows in the bottom part of Fig. 22, and fabrication of a further assembly may be started.

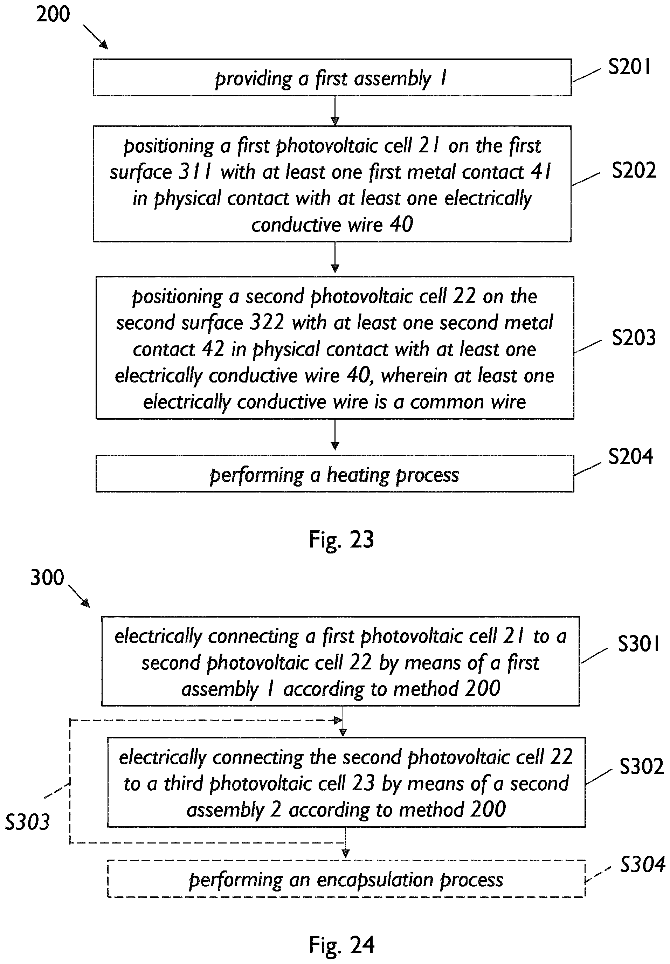

Fig. 23 shows a schematic block diagram summarizing a method 200 for electrically connecting a first photovoltaic cell 21 comprising a plurality of first metal contacts 41 at a first cell surface 211 of the first photovoltaic cell to a second photovoltaic cell 22 comprising a plurality of second metal contacts 42 at a second cell surface 222 of the second photovoltaic cell by means of a first assembly of the first aspect.

The method 200 comprises providing S201 the first assembly 1.

The method 200 further comprises positioning S202 the first photovoltaic cell 21 on the first foil surface 311 of the first electrically insulating foil 31 of the first assembly 1 with at least one first metal contact 41 of the first photovoltaic cell 21 in physical contact with at least one electrically conductive wire of the first assembly 1.

The method 200 further comprises positioning S203 the second photovoltaic cell 22 on the second foil surface 322 of the second electrically insulating foil 32 of the first assembly 1, with at least one second metal contact 42 of the second photovoltaic cell in physical contact with at least one electrically conductive wire 40 of the first assembly 21. Thereby at least one electrically conductive wire 40 of the first assembly 1 is a common wire, meaning that it is brought in physical contact with both a first metal contact 41 of the first photovoltaic cell 21 and with a second metal contact 42 of the second photovoltaic cell 22.

The method 200 further comprises performing S204 a heating process, thereby establishing an electrical connection between the at least one first metal contact 41 of the first photovoltaic cell 21 and the at least one electrically conductive wire 40 in physical contact therewith and establishing an electrical connection between the at least one second metal contact 42 of the second photovoltaic cell 22 and the at least one electrically conductive wire 40 in physical contact therewith. Thereby an electrical connection is established between the first photovoltaic cell 21 and the second photovoltaic cell 22 through, i.e. by means of, the at least one common wire.

Fig. 24 shows a schematic block diagram summarizing a method 300 for fabricating a photovoltaic device 3 comprising a plurality of photovoltaic cells 21, 22, 23. The method 300 comprises electrically connecting S301 a first photovoltaic cell 21 comprising a plurality of first metal contacts 41 at a first cell surface 211 of the first photovoltaic cell 21 to a second photovoltaic cell 22 comprising a plurality of second metal contacts 42 at a second cell surface 222 of the second photovoltaic cell 22 by means of a first assembly 1 using a method 200 of the present disclosure. The second photovoltaic cell 22 further comprises a plurality of first metal contacts 41 at a first cell surface 221 of the second photovoltaic cell.

The method 300 comprises further electrically connecting S302 the second photovoltaic cell 22 to a third photovoltaic cell 23 comprising a plurality of second metal contacts 42 at a second cell surface 232 of the third photovoltaic cell 23 by means of a second assembly 2 using a method 200 of the present disclosure.

The method 300 may comprise repeating the step of further electrically connecting S302 photovoltaic cells, to thereby electrically connect additional photovoltaic cells.

The method 300 may further comprise performing S304 an encapsulation process to thereby encapsulate the photovoltaic device 3 thus obtained.

The foregoing description details certain embodiments of the disclosure. It will be appreciated, however, that no matter how detailed the foregoing appears in text, the disclosure may be practiced in many ways. It should be noted that the use of particular terminology when describing certain features or aspects of the disclosure should not be taken to imply that the terminology is being re-defined herein to be restricted to including any specific characteristics of the features or aspects of the disclosure with which that terminology is associated.

## Claims

1. An assembly (1, 2) for electrically contacting and electrically connecting photovoltaic cells (21, 22, 23), the assembly (1, 2) comprising:
a first part (11) comprising a first electrically insulating foil (31);
a second part (12) comprising a second electrically insulating foil (32), wherein the first electrically insulating foil (31) and the second electrically insulating foil (32) are arranged relative to each other in respective positions that are laterally shifted in a first direction *x;* and
a plurality of electrically conductive wires (40) arranged substantially parallel to each other in a wire direction *w,* and substantially extending over the first electrically insulating foil (31) and over the second electrically insulating foil (32) in the first direction x,
wherein the plurality of electrically conductive wires (40) is arranged on a first foil surface (311) of the first electrically insulating foil (31) and further on a second foil surface (322) of the second electrically insulating foil (32), the first foil surface (311) and the second foil surface (322) being located at opposite sides of the assembly (1, 2),
wherein the plurality of electrically conductive wires (40) is locally attached to the first electrically insulating foil (31) and to the second electrically insulating foil (32) at predetermined attachment locations (50) without penetrating therethrough.

2. The assembly (1, 2) for electrically contacting and electrically connecting photovoltaic cells (21, 22, 23) according to claim 1 wherein at least part of the plurality of electrically conductive wires (40) is locally embedded in the first electrically insulating foil (31) and/or in the second electrically insulating foil (32) at predetermined bend locations (51).

3. The assembly (1, 2) for electrically contacting and electrically connecting photovoltaic cells (21, 22, 23) according to any of the previous claims, wherein at least part of the predetermined attachment locations (50) is shifted with respect to each other in the first direction x between respective electrically conductive wires (40).

4. The assembly (1, 2) for electrically contacting and electrically connecting photovoltaic cells (21,22, 23) according to any of the previous claims, wherein the first electrically insulating foil (31) and the second electrically insulating foil (32) are arranged next to each other, with a predetermined gap (33) there in between in the first direction *x.*

5. The assembly (1, 2) for electrically contacting and electrically connecting photovoltaic cells (21, 22, 23) according to any of claims 1 to 3 wherein the first electrically insulating foil (31) and the second electrically insulating foil (32) are arranged with a predetermined overlap (34) there in between.

6. A method (100) for fabricating an assembly (1, 2) for electrically contacting and electrically connecting photovoltaic cells (21, 22, 23), the method comprising:
- providing (S101) a first electrically insulating foil (31);
- providing (S102) a second electrically insulating foil (32);
- arranging (S103) the first electrically insulating foil (31) and the second electrically insulating foil (32) relative to each other in respective positions that are laterally shifted in a first direction x;
- providing (S104) a plurality of electrically conductive wires (40) substantially parallel to each other in a wire direction *w,* such that the plurality of electrically conductive wires (40) substantially extends over the first electrically insulating foil (31) and over the second electrically insulating foil (32) in the first direction *x,*
wherein the plurality of electrically conductive wires (40) is arranged over a first foil surface (311) of the first electrically insulating foil (31) and further over a second foil surface (322) of the second electrically insulating foil (32), the first foil surface (311) and the second foil surface (322) being located at opposite sides of the assembly; and
- locally attaching (S105) the plurality of electrically conductive wires (40) to the first electrically insulating foil (31) and to the second electrically insulating foil (32) at predetermined locations (50) without penetrating therethrough.

7. The method (100) for fabricating an assembly (1, 2) for electrically contacting and electrically connecting photovoltaic cells (21, 22, 23) according to claim 6, wherein locally attaching (S105) the plurality of electrically conductive wires (40) to the first electrically insulating foil (31) and to the second electrically insulating foil (32) comprises local heating of the plurality of electrically conductive wires (40) at the predetermined locations (50).

8. The method (100) for fabricating an assembly (1, 2) for electrically contacting and electrically connecting photovoltaic cells (21, 22, 23) according to any of claims 6 or 7, wherein providing (S101) the first electrically insulating foil (31) comprises unrolling a first roll (310) of electrically insulating material in a second direction *y* substantially orthogonal to the first direction *x* and wherein providing (S102) the second electrically insulating foil (32) comprises unrolling a second roll (320) of electrically insulating material in the second direction *y.*

9. The method (100) for fabricating an assembly (1, 2) for electrically contacting and electrically connecting photovoltaic cells (21, 22, 23) according to claim 8, further comprising cutting the first roll (310) to thereby separate the first electrically insulating foil (31) from the first roll (310) and cutting the second roll (320) to thereby separate the second electrically insulating foil (32) from the second roll (320).

10. The method (100) for fabricating an assembly (1, 2) for electrically contacting and electrically connecting photovoltaic cells (21, 22, 23) according to any of claims 6 to 9, wherein providing (S104) the plurality of electrically conductive wires (40) comprises unrolling from a bobbin.

11. The method (100) for fabricating an assembly (1, 2) for electrically contacting and electrically connecting photovoltaic cells (21, 22, 23) according to claim 10 wherein unrolling the plurality of electrically conductive wires (40) comprises unrolling substantially in the first direction x.

12. The method (100) for fabricating an assembly (1, 2) for electrically contacting and electrically connecting photovoltaic cells (21, 22, 23) according to any of claims 10 or 11, further comprising cutting the plurality of electrically conductive wires (40), after their local attachment to the first electrically insulating foil (31) and to the second electrically insulating foil (32).

13. A photovoltaic device (3) comprising an assembly (1, 2) according to any of claims 1 to 5.

14. A method (200) for electrically connecting a first photovoltaic cell (21) comprising a plurality of first metal contacts (41) at a first cell surface (211) to a second photovoltaic cell (22) comprising a plurality of second metal contacts (42) at a second cell surface (222) by means of a first assembly (1) according to any of claims 1 to 5, the method comprising:
- providing (S201) the first assembly (1);
- positioning (S202) the first photovoltaic cell (21) on the first foil surface (311) of the first electrically insulating foil (31) of the first assembly (1), with at least one first metal contact (41) of the first photovoltaic cell (21) in physical contact with at least one electrically conductive wire (40) of the first assembly (1);
- positioning (S203) the second photovoltaic cell (22) on the second foil surface (322) of the second electrically insulating foil (32) of the first assembly (1), with at least one second metal contact (42) of the second photovoltaic cell (22) in physical contact with at least one electrically conductive wire (40) of the first assembly (1);
wherein at least one electrically conductive wire (40) of the first assembly (1) is a common wire, being in physical contact with both a first metal contact (41) of the first photovoltaic cell (21) and with a second metal contact (42) of the second photovoltaic cell (22); and
- performing (S204) a heating process, thereby establishing an electrical connection between the at least one first metal contact (41) of the first photovoltaic cell (21) and the at least one electrically conductive wire (40) in physical contact therewith and establishing an electrical connection between the at least one second metal contact (42) of the second photovoltaic cell (22) and the at least one electrically conductive wire (40) in physical contact therewith,
thereby establishing an electrical connection between the first photovoltaic cell (21) and the second photovoltaic cell (22) through the at least one common wire of the first assembly (1).

15. A method (300) for fabricating a photovoltaic device (3) comprising a plurality of photovoltaic cells (21, 22, 23), the method comprising:
- electrically connecting (S301) a first photovoltaic cell (21) comprising a plurality of first metal contacts (41) at a first cell surface (211) to a second photovoltaic cell (22) comprising a plurality of second metal contacts (42) at a second cell surface (222) by means of a first assembly (1) using a method (200) according to claim 14,
wherein the second photovoltaic cell (22) further comprises a plurality of first metal contacts (41) at a first cell surface (221) of the second photovoltaic cell (22); and
- electrically connecting (S302) the second photovoltaic cell (22) to a third photovoltaic cell (23) comprising a plurality of second metal contacts (42) at a second cell surface (232) by means of a second assembly (2) using a method (200) according to claim 14.
